**Europäisches Patentamt**

**European Patent Office**

**Office européen des brevets**

(19)

(11) Veröffentlichungsnummer: **0 255 067
B1**

(12) **EUROPÄISCHE PATENTSCHRIFT**

(45) Veröffentlichungstag der Patentschrift:
**07.11.90**

(21) Anmeldenummer: **87110768.6**

(22) Anmeldetag: **24.07.87**

(51) Int. Cl.⁵: **H03K 17/08**, H02M 3/335,
H02H 7/122

(54) Schaltungsanordnung zur Strombegrenzung.

(30) Priorität: **29.07.86 DE 3625615**

(43) Veröffentlichungstag der Anmeldung:
**03.02.88 Patentblatt 88/5**

(45) Bekanntmachung des Hinweises auf die Patenterteilung:
**07.11.90 Patentblatt 90/45**

(84) Benannte Vertragsstaaten:
**AT BE CH DE ES FR GB GR IT LI NL SE**

(56) Entgegenhaltungen:
**DE-A- 3 121 754
FR-A- 2 482 800
US-A- 4 363 068
US-A- 4 447 841**

**FEINWERKTECHNIK UND MESSTECHNIK, Band 89,
Nr. 4, 1981, Seiten 187-195; R. BLÖCKL: "Der Einsatz
von SIPMOS-Transistoren in Schaltnetzteilen"**

(73) Patentinhaber: **Siemens Aktiengesellschaft,
Wittelsbacherplatz 2, D-8000 München 2(DE)**

(72) Erfinder: **Stolz, Gerhard, Dipl.-Ing., Sudetenstrasse 13,
D-8034 Germering(DE)**

## Beschreibung

Es ist bekannt, in Umrichterschaltungen als Schalttransistoren Leistungs - MOS - Feldeffekttransistoren zu verwenden. Weiterhin ist bekannt, sowohl die zu einer Umrichterschaltung selbst gehörenden Halbleiterbausteine und Induktivitäten als auch die am Gerät angeschlossenen Verbraucher dadurch gegen Überlastung zu schützen, daß die pulsförmigen Ströme in einem Zwischenkreis des Umrichters begrenzt werden. Eine derartige Begrenzung des Momentanwertes des Stromes wird in der Regel bei einer Überlast am Ausgang des Umrichters, bei dynamischen Vorgängen, z.B. beim Ein- und Ausschalten des Umrichters oder bei Bauteilefehlern wirksam.

Die Erfindung bezieht sich auf eine wie im Oberbegriff des Patentspruches 1 angegebene Schaltungsanordnung zur Strombegrenzung.

Eine derartige Schaltungsanordnung ist bereits aus Reinhard Blöckl "Der Einsatz von Sipmos-Transistoren in Schaltnetzteilen", Feinwerktechnik und Meßtechnik 89 (1981) 4, Seite 187 bis Seite 195, insbesondere Seite 193, Bild 12 und Seite 194, Bild 13 bekannt. Bei dem bekannten Gleichspannungsumrichter wird der pulsförmige Strom des MOS-FETs mit Hilfe eines Meßwiderstandes gemessen, der in der Source-Zuleitung des Feldeffekttransistors angeordnet ist. Ein derartiger Meßwiderstand muß wegen der vergleichsweise hohen Stromanstiegs- und Abfallzeiten induktivitätsarm aufgebaut und für die in ihm auftretenden Verluste ausgelegt sein. Dies ist mit einem nicht zu vernachlässigenden Aufwand und mit zusätzlichen Verlusten verbunden.

Man kann andererseits den pulsförmigen Strom eines MOS-Schalttransistors mit Hilfe eines Stromwandlers bzw. Übertragers messen. Wegen der Rückmagnetisierung des Stromwandlers ergibt sich hierbei eine Einschränkung des durch das Verhältnis von Einschaltdauer zu Ausschaltdauer gegebenen Stromfluß-Verhältnisses.

Sowohl bei Verwendung eines Strommeßwiderstandes als auch beim Einsatz eines Stromwandlers ist die Strommeßvorrichtung mit einem - bedingt durch die vergleichsweise großen Abmessungen des Stromsensors - unerwünscht großen Raumbedarf verbunden.

Aufgabe der Erfindung ist es, eine wie im Oberbegriff des Patentanspruchs 1 angegebene Schaltungsanordnung derart auszubilden, daß die Momentanwert-Strombegrenzung mit geringen zusätzlichen Verlusten verbunden ist. Insbesondere soll die Schaltungsanordnung zur Momentanwertstrombegrenzung in fremdgetakteten Umrichtern geeignet sein.

Leistungs-MOS-Feldeffekttransistoren besitzen im eingeschalteten bzw. gesättigten Zustand einen Drain-Source-Widerstand, der im zulässigen Arbeitsberich des Feldeffekttransistors unabhängig vom durchflossenen Strom etwa konstant bleibt. Dabei liegt dieser je nach Transistortyp bei einigen Milliohm bis einigen Ohm. Eine Erkenntnis im Rahmen der Erfindung besteht darin, daß man diese Eigenschaft des Feldeffekttransistors zur Lösung der gestellten Aufgabe ausnutzen kann, wenn man die Strommessung auf die Zeitabschnitte beschränkt, in denen sich der Feldeffekttransistor im Sättigungszustand befindet.

Gemäß der Erfindung wird die Aufgabe durch die im kennzeichnenden Teil des Patentanspruchs 1 angegebenen Maßnahmen gelöst.

Da die Strommeßvorrichtung die Drain-Source-Strecke des Feldeffekttransistors enthält, brauchen gegebenenfalls vorhandene zusätzliche Bauteile der Strommeßvorrichtung nur einen gegenüber vergleichbaren bekannten Vorrichtungen kleineren Beitrag zur stromproportionalen Meßspannung zu liefern. Ein gegebenenfalls vorhandener zusätzlicher Meßwiderstand kommt daher mit einem ver-gleichsweise geringen Widerstandswert aus. Im Hinblick auf die geringere Verlustleistung kön-en für derartige Bauteile, falls solche in der Strommeßvorrichtung überhaupt enthalten sind, besonders raumsparende und wenig aufwendige Bauformen Verwendung finden. Da der Bahnwiderstand des Feldeffekttransistors mit der Temperatur wächst, wird der Strom bei höherer Temperatur auf niedrigere Werte begrenzt, so daß der Feldeffekttransistor in vorteilhafter Weise besonders wirksam gegen Überlastung geschützt ist.

Eine Temperaturunabhängigkeit des Grenzwertes der Strombegrenzung läßt sich dadurch erzielen, daß man die temperaturabhängige Änderung des Bahnwiderstandes mit einer sich gleichfalls ändernden Referenz kompensiert.

In weiterer Ausgestaltung der Erfindung besteht die Strommeßvorrichtung aus der Drain-Source-Strecke des Feldeffekttransistors allein; wobei der dem Transistorstrom proportionale Spannungsabfall am Drain-Source-Widerstand direkt zur Strommessung und Strombegrenzung herangezogen wird. In diesem Fall entfällt die mit einem Strommeßwiderstand verbundene zusätzliche Verlustleistung. Der Drain-Source-Widerstand des gesättigten Feldeffekttransistors erhöht sich proportional mit der Chiptemperatur und zwar im zulässigen Temperaturbereich etwa bis zu einem Faktor 2. Bereits ohne Ergänzung zu einem Zweipolnetzwerk ergibt sich dabei ein Temperaturgang der Strombegrenzung, der als solcher bzw. ohne Korrektur in einem Zweipolnetzwerk einen wirksamen Überlastungsschutz in einem großen Arbeitsbereich gewährleistet.

Weitere vorteilhafte Ausgestaltungen der Erfindung ergeben sich aus den Patentansprüchen 3 bis 5.

Die Erfindung wird anhand der in den Fig. 1 und 2 gezeigten Ausführungsbeispiele sowie anhand des in Fig. 3 dargestellten Impulstelegrammes näher erläutert.

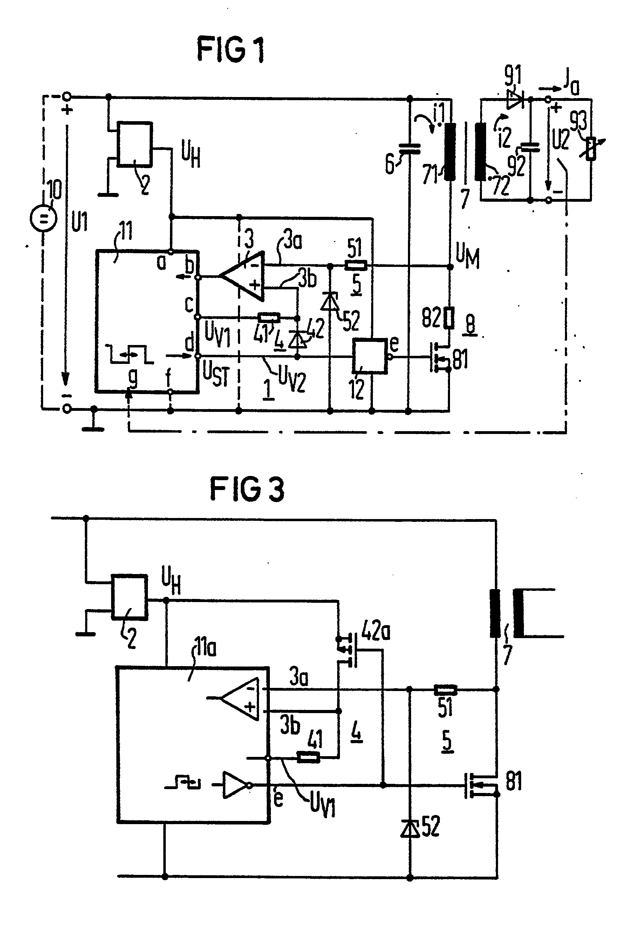

Fig. 1 einen als Sperrumrichter ausgebildeten Gleichspannungsumrichter mit einem Feldeffekttransistor als elektronischer Schalter,

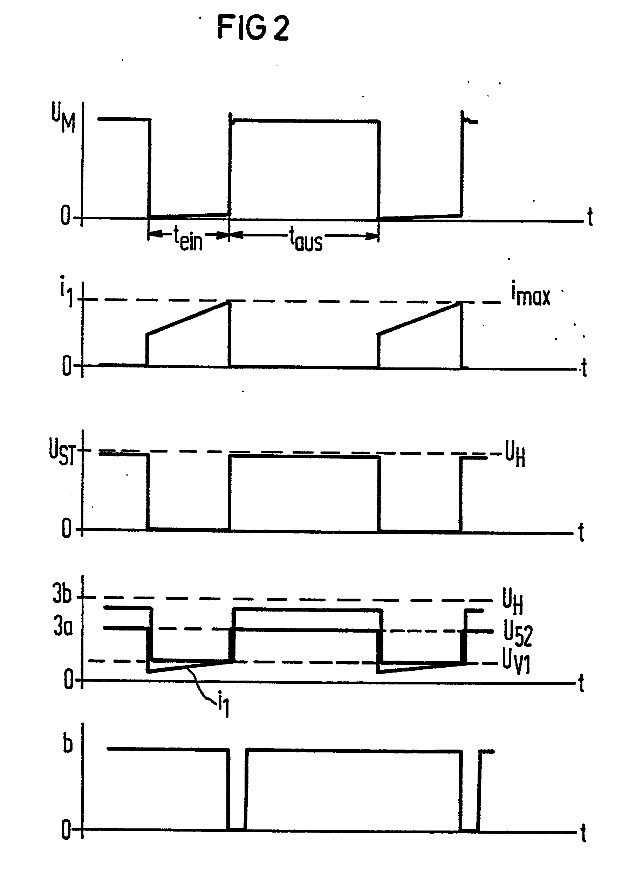

Fig. 2 für den in Fig. 1 gezeigten Gleichspannungsumrichter ein Impulsdiagramm, aus dem Spannungen und Ströme im Falle einer ausgangsseitigen Überlast hervorgehen und

Fig. 3 einen Sperrumrichter nach Fig. 1 mit einem Transistor zur Umschaltung der Vergleichsspannung.

Fig. 1 zeigt einen Sperrumrichter, der eine Schaltungsanordnung zur dynamischen Strombegrenzung enthält. Im Hauptstromkreis des Sperrumrichters liegt als elektronischer Schalter der Feldeffekttransistor 81. Der Hauptstromkreis führt vom Pluspol der Gleichspannungsquelle 10 über die Primärwicklung 71 des Transformators 7, den Strommeßwiderstand 82 zur Drain-Elektrode des Feldeffekttransistors 81. Die Source-Elektrode des Feldeffekttransistors 81 ist unmittelbar mit dem an Bezugspotential bzw. Masse liegenden Minuspol der Gleichspannungsquelle 10 verbunden. Parallel zur Gleichspannungsquelle 10 liegt einerseits der Kondensator 6, andererseits der Eingang der Vorrichtung 2, die zur Erzeugung der Hilfsspannung $U_H$ dient.

Die Sekundärwicklung 72 des Transformators 7 ist über die Diode 91 an den Kondensator 92 geführt. Die Anschlüsse des Kondensators 92 bilden den Ausgang des Sperrumrichters. An den Ausgang des Sperrumrichters ist der Lastwiderstand 93 angeschlossen, der verschiedene Werte annehmen kann und daher als stufenlos veränderbarer Widerstand dargestellt ist. Der Sperrumrichter gibt an seinem Ausgang die Ausgangsspannung $U_a$ und den Ausgangsstrom $I_a$ ab. In der Primärwicklung 71 des Transformators 7 fließt der pulsförmige Primärstrom $i_1$. Über die Diode 91 fließt der pulsförmige Sekundärstrom $i_2$.

Die Gate-Elektrode des Feldeffekttransistors 81 ist an den Treiberausgang e der Steueranordnung 1 angeschlossen. Die Steueranordnung 1 gibt am Treiberausgang e eine Folge von Treiberpulsen ab, die ein den Feldeffekttransistor 81 leitend steuerndes Einschaltpotential bzw. sperrend steuerndes Ausschaltpotential aufweisen.

Die Strommeßvorrichtung 8 besteht aus der Drain-Source-Strecke des Feldeffekttransistors 81 und dem dazu in Serie angeordneten Strommeßwiderstand 82. Der Strommeßwiderstand 82 kann entfallen, so daß die Strommeßvorrichtung aus der Source-Dranin-Strecke des Feldeffekttransistors 81 allein besteht.

Die Steuerschaltung 11 hat einen Eingang a für eine Versorgungsspannung, einen Anschluß f zum Anschluß eines Bezugspotentials, einen Anschluß b zum Anschluß einer Strommeßvorrichtung zur dynamischen Strombegrenzung, einen Ausgang c für eine Vergleichsspannung $U_{V1}$, einen Ausgang d für eine impulsförmige Steuerspannung $U_{ST}$, deren Tastgrad durch die an den Eingang g geführte Meßspannung gesteuert ist. Die Steuerschaltung 11 gibt an ihrem Ausgang d eine pulsbreitenmodulierte Steuerspannung $U_{St}$ ab und kann durch einen handelsüblichen integrierten Steuerbaustein gebildet sein.

Der Schalttransistor 81 wird von der Steuerschaltung 11, die die Steuerspannung $U_{St}$ abgibt, über den Inverter-Treiber 12 mit einem Tastgrad, gegeben als Verhältnis $t_{ein}$ zu $t_{aus}$, gesteuert, wobei $t_{ein}$ die Einschaltdauer und $t_{aus}$ die Ausschaltdauer des Feldeffekttransistors 81 sind. Dieser Tastgrad hängt von den Werten der Ein- und Ausgangsspannung des Gleichspannungsumrichters ab. Bei Ausgangs-Überlast ist der Tastgrad so weit zu reduzieren, daß der Primärstrom $i_1$, der im primären Wechselstromzwischenkreis fließt, und damit der Sekundärstrom $i_2$ einen für die Bauelemente des Gleichspannungsumrichters zulässigen Wert nicht überschreitet.

Die Steuerschaltung 11, der Treiber 12 und der Komparator 3 werden mit der Hilfsspannung $U_H$ gespeist. Die Hilfsspannung $U_H$ wird mit Hilfe der Vorrichtung 2 aus der Spannung U1 der Vergleichsspannungsquelle 10 gewonnen. Die Vorrichtung 2 ist in üblicher Weise aufgebaut, insbesondere als Hilfsumrichter oder als Spannungsstabilisator. Gegebenenfalls kann abweichend von Fig. 1 zusätzlich zur Gleichspannungsquelle 10 eine unabhängige Hilfsspannungsquelle Verwendung finden.

Der Minuseingang 3a des Komparators 3 ist über den Widerstand 51 an den Verbindungspunkt von Strommeßwiderstand 82 und Primärwicklung 71 angeschlossen. Der Pluseingang 3b des Komparators 3 läßt sich mit Hilfe eines elektronischen Umschalters wahlweise an die Vergleichsspannung $U_{V1}$ oder an die Vergleichsspannung $U_{V2}$ legen. Die betragsmäßig kleinere Vergleichsspannung $U_{V1}$ ist dann wirksam, wenn am Treiberausgang e das Einschaltpotential liegt. Die betragsmäßig größere Vergleichsspannung $U_{V2}$ ist bei am Treiberausgang e liegenden Sperrpotential wirksam.

Die Vorrichtung 2 zur Hilfsspannungserzeugung kann z.B. aus einer Stabilisierungsschaltung mit dem Widerstand und einer der Z-Diode bestehen. Die Steuerschaltung 11, der Komparator 3 und der Treiber 12 werden mit der Hilfsspannung $U_H$, versorgt.

Der nichtinvertierende bzw. Pluseingang 3b des Komparators 3 ist einerseits über den Widerstand 41 mit dem Ausgang c für die Vergleichsspannung $U_{V1}$ und andererseits über die Diode 42 an den Ausgang d der Steuerschaltung 11 angeschlossen. Die Diode 42 ist derart gepolt, daß sie bei leitendem Feldeffekttransistor 81 gesperrt und bei gesperrtem Feldeffekttransistor 81 leitend ist.

Der in Fig. 1 gezeigte Gleichspannungsumrichter hat die folgende aus Fig. 3 ersichtliche Funktion:

Der Spannungshub des digitalen Steuersignals $U_{St}$ entspricht nahezu der Hilfsspannung $U_H$. Die Referenzspannung $U_V$ beträgt insbesondere $i_{1max} \cdot (R_{DS\,on\,max} + R_{82})$, wobei

$i_{1max}$ der Maximalwert des Primärstromes und

$R_{DS\,on\,max}$ der Maximalwert des Drain-Source-Widerstandes

des Feldeffekttransistors 81 und $R_{82}$ der Wert des Widerstandes 82 ist.

Als Einschaltbefehl gibt die Steuerschaltung 11 ein Steuersignal $U_{St}$ mit Logikpegel 0 bzw. niedrigem Spannungspegel an den Inverter 12 ab. Vom Ausgang des Inverters 12 gelangt Logikpegel 1 bzw. hoher Spannungspegel an das Gate des Feldeffekttransistors 81. Der Feldeffekttransistor 81 wird leitend gesteuert. Der Primärstrom $i_1$ beginnt ent-

sprechend der Induktivität des als Speicherübertrager dienenden Transformators 7 von Null oder einem bestimmten Anfangswert auszusteigen.

Gleichzeitig liegt am nichtinvertierenden Eingang 3b des Komparators 3 über den Widerstand 41 die Vergleichsspannung $U_{V1}$. Am invertierenden Eingang 3a des Komparators 3 liegt über den Widerstand 51 die Meßspannung $U_M$, die an der Serienschaltung aus dem durchgeschalteten Feldeffekttransistor 81 und dem Meßwiderstand 82 abfällt. Erreicht bzw. übersteigt - z.B.durch Überlast am Ausgang - die dem Primärstrom $i_1$ proportionale Meßspannung

$$U_M = U_{Drain} + U_{R82}$$

mit $U_{Drain} = i_1 . R_{DS\ on}$ und

$$U_{R82} = i_1 . R_{82}$$

die Referenzspannung $U_{V1}$, so schaltet der Komparator 3 an seinem Ausgang um und gibt damit der Steuerschaltung 11 den Befehl, den Feldeffekttransistor 81 bereits zu einem früheren Zeitpunkt als bei Normallast zu sperren.

Die Meßspannung $U_M$ steigt nun auf einen Spannungswert an, der ungefähr gleich der Summe aus der Eingangsspannung $U_1$ und der durch den Transformator 7 in den Primärstromkreis transformierten Ausgangsspannung $U_2$ ist.

Dieser Spannungswert ist für den Eingang des Komparators 3 zu groß und wird über den Widerstand 51 auf den Wert der Zenerspannung der Z-Diode 52 begrenzt. Die Zenerspannung $U_Z$ der Z-Diode 5 ist größer als die Vergleichsspannung $U_{V1}$ und kleiner als der um die Durchlaßspannung der Diode 52 verminderte Wert der Steuerspannung $U_{St}$ bei Logikpegel 1 bzw. hohem Spannungspegel. Der Komparator 3 schaltet an seinem Ausgang während der Sperrzeit des Feldeffekttransistors 81 wieder in seinen ursprünglichen Zustand zurück, da der positive Spannungspegel an seinem nichtinvertierenden Eingang 3b größer als die am invertierenden Eingang 3a liegende Zenerspannung $U_Z$ ist.

Vorzugsweise besteht die Strommeßvorrichtung 8 aus dem Feldeffekttransistor allein, so daß der Widerstand R82 und somit die Spannung $U_{R82}$ entfallen.

Die Schaltungsanordnung nach Fig. 3 stimmt mit der nach Fig. 1 weitgehend überein. Abweichend von Fig. 1 ist der Treiber 12 und der Komparator 3 in der Steuerschaltung 11a, die z.B. vom Typ UC 3526 ist, enthalten. Als Umschalter für die Vergleichsspannungen am Eingang 3b dient anstatt der Diode 42 in Fig. 1 der Transistor 42a. Der Transistor 42a wird vom Ausgang e des Treibers gesteuert Die Strommeßvorrichtung 8 besteht aus dem Feldeffekttransistor allein.

**Patentansprüche**

1. Schaltungsanordnung zur Strombegrenzung, die in wenigstens einem Hauptstromkreis eine Strommeßvorrichtung und als elektronischen Schalter einen Feldeffekttransistor (81) enthält, dessen Gate an einen Treiberimpulsausgang (e) einer Steueranordnung (1) angeschlossen ist, die am Treiberimpulsausgang (e) eine Folge von Treiberimpulsen mit einem den Feldeffekttransistor (81) leitend steuernden Einschaltpotential abgibt, wobei die Steueranordnung (1) durch einen Komparator (3) derart steuerbar ist, daß sie bei Aktivierung des Komparators (3) an ihrem Steuerimpulsausgang (e) von Einschaltpotential auf Sperrpotential zurückschaltet, **dadurch gekennzeichnet,** daß die Strommeßvorrichtung (8) die Drain-Source-Strecke des Feldeffekttransistors (81) enthält und daß der Komparator (3) mit seinem Minuseingang (3a) über einen Spannungsbegrenzer (5) an die Strommeßvorrichtung (8) und mit seinem Pluseingang (3b) an zwei durch die Steueranordnung (1) wahlweise wirksam steuerbare Vergleichsspannungen ($U_{V1}$, $U_{V2}$) angeschlossen ist und daß von den Vergleichsspannungen die eine ($U_{V1}$) bei am Treiberimpulsausgang (e) liegenden Einschaltpotential eine gegenüber der Ausgangsspannung des Spannungsbegrenzers (5) betragsmäßig kleiner ist und die andere am Treiberimpulsausgang (e) liegendem Sperrpotential wirksam und gegenüber der begrenzten Ausgangsspannung des Spannungsbegrenzers (5) betragsmäßig größer ist.

2. Schaltungsanordnung nach Anspruch 1, **dadurch gekennzeichnet,** daß die Strommeßvorrichtung (8) aus der Drain-Source-Strecke des Feldeffekttransistors (81) allein besteht.

3. Schaltungsanordnung nach Anspruch 1 oder 2, **dadurch gekennzeichnet,** daß der Pluseingang (3b) des Komparators (3) über einen Widerstand (41) an einen Anschluß (c) für die erste Vergleichsspannung ($U_{V1}$) und über einen durch die Steuerspannung ($U_{St}$) steuerbaren elektronischen Schalter (Diode 42) an einen Anschluß (d) für die zweite Vergleichsspannung (Amplitude der Steuerspannung $U_{St}$) angeschlossen ist.

4. Schaltungsanordnung nach Anspruch 3, **dadurch gekennzeichnet,** daß die Steueranordnung (1) eine Steuerschaltung (11) und einen durch Steuerimpulse der Steuerschaltung (11) steuerbaren invertierenden Treiber enthält und daß die zweite Vergleichsspannung ($U_{V2}$) durch die Amplitude der impulsförmigen Steuerspannung ($U_{St}$) gebildet ist und daß der nichtinvertierende Eingang (3b) des Komparators (3) über eine derart gepolte Diode (42) an den Steuerimpulsausgang (d) der Steuerschaltung (11) angeschlossen ist, daß die Diode (42) bei am Ausgang des Treibers (12) liegendem Einschaltpotential gesperrt und bei am Ausgang des Treibers (12) liegendem Sperrpotential leitend ist.

5. Schaltungsanordnung nach einem der Ansprüche 1 bis 4, **dadurch gekennzeichnet,** daß die Steueranordnung (1) als Steuerschaltung (11) einen Regler zur Veränderung der Dauer der Treiberimpulse in Abhängigkeit von einer Regelgröße ($U_2$) enthält.

## Claims

1. Circuit arrangement for current limitation which contains in at least one main circuit a current measuring device and, as electronic switch, a field-effect transistor (81), the gate of which is connected to a driver pulse output (e) of a control arrangement (1) which outputs at the driver pulse output (e) a train of driver pulses having a turn-on potential which renders the field-effect transistor (81) conductive, it being possible to control the control arrangement (1) by means of a comparator (3) in such a way that when the comparator (3) is activated, it switches back from turnon potential to blocking potential at its control pulse output (e), characterized in that the current measuring device (8) contains the drain-source path of the field-effect transistor (81), and in that the comparator (3) is connected by its minus input (3a) via a voltage limiter (5) to the current measuring device (8) and by its plus input (3b) to two reference voltages ($U_{V1}$, $U_{V2}$) which can be alternatively activated by the control arrangement (1), and in that of the reference voltages, given the presence of turn-on potential at the driver pulse output (e), the one ($U_{V1}$) is smaller in comparsion to the output voltage of the voltage limiter (5), and, given the presence of blocking potential at the driver pulse output (e), the other is active and is greater in comparison to the limited output voltage of the voltage limiter (5).

2. Circuit arrangement according to Claim 1, characterized in that the current measuring device (8) consists solely of the drain-source path of the field-effect transistor (81).

3. Circuit arrangement according to Claim 1 or 2, characterized in that the plus input (3b) of the comparator (3) is connected via a resistor (41) to a terminal (c) for the first reference voltage ($U_{V1}$), and is connected to a terminal (d) for the second reference voltage (amplitude of the control voltage $U_{St}$) via an electronic switch (diode 42) which can be controlled by the control voltage ($U_{St}$).

4. Circuit arrangement according to Claim 3, characterized in that the control arrangement (1) contains a control circuit (11) and an inverting driver which can be controlled by control pulses of the control circuit (11), and in that the second reference voltage ($U_{V2}$) is formed by the amplitude of the pulse-shaped control voltage ($U_{St}$), and in that the non-inverting input (3b) of the comparator (3) is connected to the control pulse output (d) of the control circuit (11) via a diode (42) which is polarized in such a way that the diode (42) blocks given the presence of turn-on potential at the output of the driver (12) and is conductive given the presence of blocking potential at the output of the driver (12).

5. Circuit arrangement according to one of Claims 1 to 4, characterized in that the control arrangement (1) contains as control circuit (11) a controller for varying the duration of the driver pulses as a function of a controlled variable ($U_2$).

## Revendications

1. Montage de limitation d'un courant, comportant, dans au moins un circuit principal de courant, un dispositif de mesure du courant et, comme interrupteur électronique, un transistor à effet de champ (81) dont la grille est reliée à une sortie d'impulsions d'attaque (e) d'un dispositif de commande (1) qui émet, à la sortie (e) des impulsions d'attaque, un train d'impulsions d'attaque à un potentiel de fermeture qui commande le transistor à effet de champ (81) dans son état passant, ledit dispositif de commande (1) étant susceptible d'être commandé de telle façon par un comparateur (3) que lors de l'activation du comparateur (3), sa sortie (e) des impulsions de commande repasse du potentiel de fermeture au potentiel d'ouverture, caractérisé par le fait que le dispositif de mesure du courant (8) comporte le circuit drain-source du transistor à effet de champ (81) et que le comparateur (3) est relié par son entrée négative (3a), et par l'intermédiaire d'un limiteur de tension (5), au dispositif de mesure du courant (8), alors que son entrée positive (3b) est reliée à deux tensions de comparaison ou de référence ($U_{V1}$, $U_{V2}$) susceptibles d'être commandées, au choix, dans leur état efficace à l'aide du dispositif de commande (1), et que parmi les tensions de référence, l'une ($U_{V1}$) possède, lorsque la sortie (e) des impulsions d'attaque est au potentiel de fermeture, une valeur faible par rapport à la tension de sortie du limiteur de tension (5), alors que l'autre possède, lorsque la sortie (e) des impulsions d'attaque est au potentiel de blocage, une valeur efficace et plus grande comparativement à la tension de sortie limitée du limiteur de tension (5).

2. Montage selon la revendication 1, caractérisé par le fait que le dispositif de mesure du courant (8) est constitué uniquement par le circuit drain-source du transistor à effet de champ (81).

3. Montage selon la revendication 1 ou 3, caractérisé par le fait que l'entrée positive (3b) du comparateur (3) est reliée, par l'intermédiaire d'une résistance (41), à une borne (c) pour la première tension de référence ($U_{V1}$) et qu'elle est reliée, par l'intermédiaire d'un interrupteur électronique (diode 42) qui est susceptible d'être commandé par la tension de commande ($U_{St}$), à une borne (d) pour la seconde tension de référence (amplitude de la tension de commande $U_{St}$).

4. Montage selon la revendication 3, caractérisé par le fait que le dispositif de commande (1) comporte un circuit de commande (11) et un dispositif d'attaque inverseur, commandé par des impulsions de commande du circuit de commande (11), et que la seconde tension de référence ($U_{V2}$) est formée par l'amplitude de la tension de commande de forme impulsionnelle ($U_{St}$), et que l'entrée non inverseuse (3b) du comparateur (3) est reliée à la sortie des impulsions de commande (d) du circuit de commande (11), par l'intermédiaire d'une diode (42) qui est polarisée de telle façon que celle-ci est bloquée lorsque la sortie du dispositif d'attaque (2) est portée au potentiel de fermeture, alors qu'elle dans son état passant lorsque la sortie du dispositif d'attaque (2) est portée au potentiel de blocage.

5. Montage selon l'une des revendications 1 à 4, caractérisé par le fait que le dispositif de commande (1) comporte, en tant que circuit de commande (11), un régulateur pour modifier la durée des impulsions d'attaque en fonction d'une grandeur de réglage $(U_2)$.

# FIG 1

# FIG 3

# FIG 2